Europäisches Patentamt

European Patent Office

Office européen des brevets

(19)

(11) **EP 0 924 526 B1**

(12) **FASCICULE DE BREVET EUROPEEN**

(45) Date de publication et mention
de la délivrance du brevet:
**04.04.2001 Bulletin 2001/14**

(51) Int Cl.⁷: **G01R 31/02**

(21) Numéro de dépôt: **98403034.6**

(22) Date de dépôt: **03.12.1998**

(54) **Dispositif de détection d'un défaut sur une ligne HTA d'un réseau de distribution d'energie électrique**

Gerät zur Fehlererfassung in elektrischen Hochspannungsfreileitungen in einem elektrischen Energiverteilungsnetz

Device for detecting a fault on a high voltage overhead line in an electrical energy distribution network

(84) Etats contractants désignés:
**AT BE CH CY DE DK ES FI FR GB GR IE IT LI LU MC NL PT SE**

(30) Priorité: **08.12.1997 FR 9715493**

(43) Date de publication de la demande:
**23.06.1999 Bulletin 1999/25**

(73) Titulaire: **Manufacture D'Appareillage Electrique de Cahors
46000 Cahors (FR)**

(72) Inventeur: **Grandjean, Hervé (FR)**

(74) Mandataire: **Keib, Gérard
NOVAMARK TECHNOLOGIES
Anciennement Brevets Rodhain & Porte
122, Rue Edouard Vaillant
92593 Levallois Perret Cedex (FR)**

(56) Documents cités:
**EP-A- 0 586 273**

## Description

La présente invention concerne un dispositif de détection de défauts sur un réseau aérien de distribution d'énergie électrique comportant, dans un coffret solidaire du support de ligne, un circuit électronique relié à au moins un premier capteur sensible aux variations transitoires du courant homopolaire de la ligne à surveiller, et à au moins un deuxième capteur sensible aux variations transitoires de la tension homopolaire de ladite ligne, ledit circuit électronique effectuant une détection de défaut basée sur la comparaison des signes desdites variations transitoires des courants homopolaires et desdites variations transitoires des tensions homopolaires.

Les dispositifs de détection de défauts connus dans l'art antérieur, voir par exemple EP-A-586 273 (ELECTRICTE DE FRANCE), utilisent un principe de détection «ampéremètrique» pour détecter des défauts polyphasés, ou un principe de détection directionnelle, nécessitant la mesure du courant et de la tension homopolaire, pour détecter des défauts à la terre. Ces dispositifs utilisent soit des détecteurs souterrains installés en cabine dans des postes de transformation HTA/BT par exemple, soit des détecteurs aériens, dits de proximité " installés dans un coffret en pied de poteau support de ligne HTA. Dans le premier cas, la mesure du courant est faite généralement par des tores placés sur chacune des phases, tandis que la mesure de la tension est faite généralement par des diviseurs capacitifs, tandis que dans le deuxième cas la mesure du courant est faite par un capteur de champ magnétique et la mesure de la tension est faite par un capteur de champ électrique.

Selon la nature du poteau support de ligne (béton armé, métal, bois...) la répartition des lignes d'équipotentielles et donc des lignes de champ électrique peut être très différente.

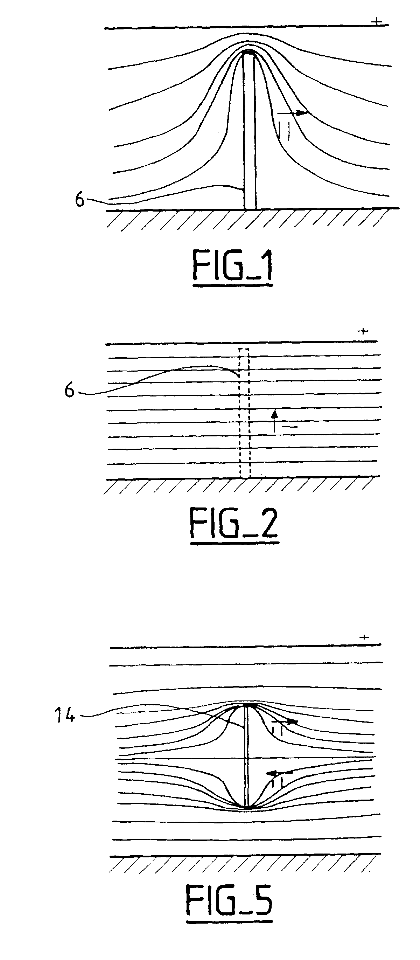

Aussi, comme cela est illustré par la figure 1, dans le cas d'un poteau à structure métallique on constate un champ électrique beaucoup plus intense au sommet du poteau et un champ presque nul dans l'angle formé par le bas du poteau et le sol. Dans le cas d'un poteau en bois, si l'on considère le support comme un isolant parfait, les lignes d'équipotentielles se répartissent uniformément entre le sommet dudit poteau et le sol comme cela est illustré par la figure 2. Cependant, la réalité montre qu'un poteau en bois ne peut être considéré comme un isolant parfait et de ce fait, comme un poteau à structure métallique, dévie les lignes de champ électrique. Il en résulte une difficulté de connaître l'orientation des lignes de champ et donc de trouver la position optimale pour le capteur du champ électrique.

Le but de l'invention est de résoudre le problème ci-dessus au moyen d'un dispositif simple, peu coûteux et permettant une mesure optimale des variations du champ électrique au voisinage du poteau support de ligne.

Selon l'invention, le coffret contenant les détecteurs comporte au moins un élément conducteur destiné à conférer une orientation connue aux lignes de champ électrique au voisinage du support de ligne.

Ceci permet de connaître précisément la répartition desdites lignes de champ au voisinage du support de lignes et de positionner le capteur de champ électrique de telle sorte qu'il soit traversé par un champ électrique maximal.

D'autres caractéristiques et avantages de l'invention ressortiront de la description qui va suivre, prise à titre d'exemple non limitatif, en référence aux figures annexées dans lesquelles :

- La figure 1 représente un schéma illustrant la répartition des lignes de champ électrique au voisinage d'un support à structure métallique ;
- la figure 2 représente un schéma illustrant la répartition des lignes de champ électrique au voisinage d'un support en matériau isolant parfait;
- la figure 3 un schéma général d'un dispositif selon l'invention ;
- la figure 4 représente un premier mode de réalisation du dispositif selon l'invention ;
- la figure 5 représente un schéma illustrant la répartition des lignes de champ électrique au voisinage d'un support comportant un dispositif conforme à l'invention
- la figure 6 représente un deuxième mode de réalisation du dispositif selon l'invention.
- la figure 7 représente un schéma électrique d'un capteur de champ électrique équipant un dispositif selon l'invention.

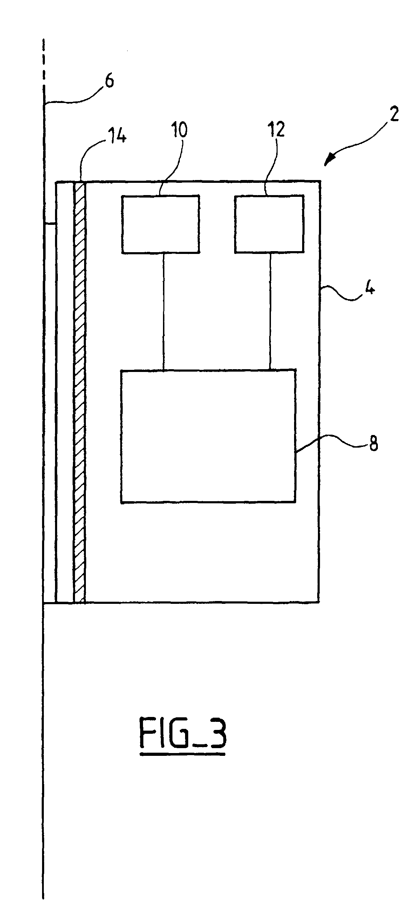

La figure 3 représente un dispositif 2 de détection de défauts sur un réseau aérien de distribution d'énergie électrique comportant, dans un coffret 4 solidaire du support de ligne 6, un circuit électronique 8 relié à au moins un premier capteur 10 sensible aux variations transitoires du courant homopolaire de la ligne à surveiller, et à au moins un deuxième capteur 12 sensible aux variations transitoires de la tension homopolaire de ladite ligne, ledit circuit électronique 8 effectuant une détection de défaut basée sur la comparaison des signes desdites variations transitoires des courants homopolaires et desdites variations transitoires des tensions homopolaires.

Le coffret 4 comporte un élément conducteur 14 destiné à conférer une orientation connue aux lignes de champ électrique au voisinage du support de ligne 6.

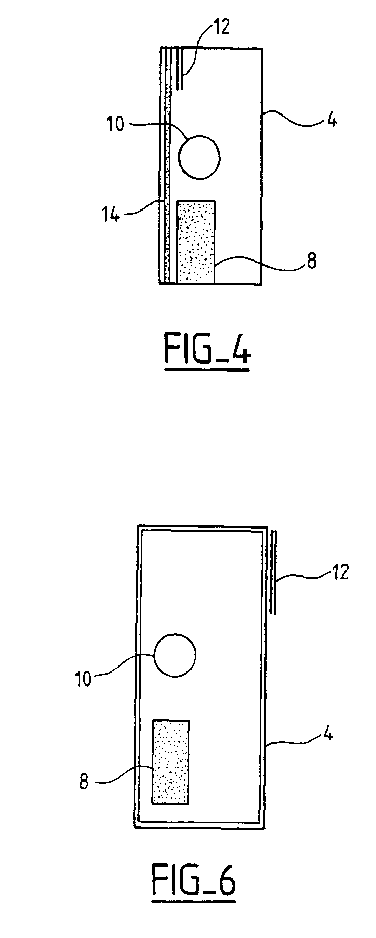

Selon un premier mode de réalisation illustré par la figure 4, ledit élément conducteur 14 est constitué par une plaque conductrice agencée dans le fond du coffret 4.

Comme on peut le voir sur la figure 5 représentant schématiquement la répartition des lignes d'équipotentielles autour de la plaque conductrice 14, celle-ci se met au potentiel de la ligne de champ électrique qui la traverse en son milieu. Il en résulte une déformation symétrique des lignes d'équipotentielles voisines, avec une zone de champ électrique plus intense en périphérie de ladite plaque, et une zone de champ électrique nul en son centre.

En positionnant le capteur à proximité de l'une des extrémités de ladite plaque conductrice, ce dernier sera traversé par un champ électrique horizontal.

Selon un deuxième mode de réalisation de l'invention illustré par la figure 6, l'élément conducteur 14 est constitué par l'une au moins des parois du coffret 4, en matériau conducteur ou semiconducteur, et le deuxième capteur 12 sensible aux variations transitoires de la tension homopolaire est placé à l'extérieur dudit coffret 4.

Dans un autre mode de réalisation de l'invention, toutes les parois du coffret 4 sont rendues conductrices par application, sur leur surface, d'une couche de peinture conductrice.

Ce mode de réalisation permet de réduire l'influence des autres composants contenus dans le coffret 4 sur l'orientation des lignes de champ électrique.

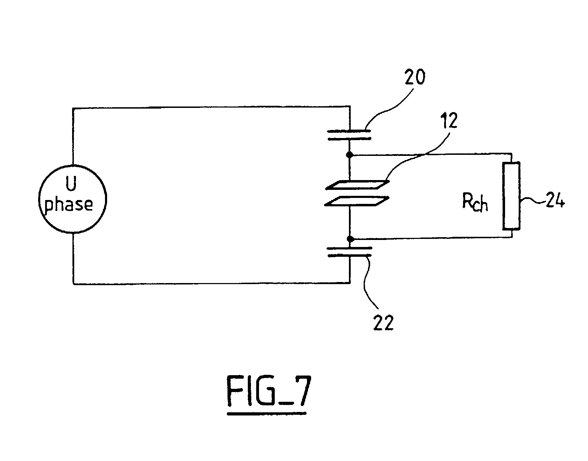

De façon connue en soi, le premier capteur 10 est constitué par une bobine tandis que le deuxième capteur 12 est constitué par deux armatures conductrices, formant condensateur et noyées dans le champ électrique de la ligne à surveiller. La figure 7 représente un schéma électrique équivalent d'un tel deuxième capteur 12. Ce dernier est équivalent à un condensateur de capacité

$$C = 8,85 \times 10^{-12} \times \frac{\varepsilon S}{e}$$

où $\varepsilon$ représente la permittivité de l'isolant par rapport au vide, S représente la surface des armatures en conductrices regard constituant le condensateur et e représente l'épaisseur du diélectrique. Ce condensateur est couplé à la ligne HTA par deux capacités de couplage 20 et 22 et est monté en parallèle avec une résistance de charge $R_{CH}$ 24.

Ce schéma électrique présente une réponse en fréquence de type « passe-haut » avec une fréquence de coupure déterminée par le rapport $R_{CH}/\langle C_L + C\rangle$. Il en résulte que la taille du capteur est déterminée en fonction de la résistance d'entrée du circuit électronique 8 et de la fréquence minimale du signal à étudier qui est de 50 Hz. Un étage de filtrage et d'amplification destiné à extraire la composante fondamentale à 50Hz du courant homopolaire est prévu à l'entrée du circuit électronique 8.

## Revendications

**1.** Dispositif (2) de détection de défauts sur un réseau aérien de distribution d'énergie électrique comportant un circuit électronique (8) relié à au moins un premier capteur (10) sensible aux variations transitoires du courant homopolaire de la ligne à surveiller, et à au moins un deuxième capteur (12) sensible aux variations transitoires de la tension homopolaire de ladite ligne, ledit circuit électronique (8) effectuant une détection de défaut basée sur la comparaison des signes desdites variations transitoires des courants homopolaires et desdites variations transitoires des tensions homopolaires, caractérisé en ce que le circuit électronique (8) relié à au moins un premier capteur (10) se trouve dans un coffret (4) solidaire du support de ligne (6) et que le coffret (4) comporte au moins un élément conducteur (14) destiné à conférer une orientation connue aux lignes de champ électrique au voisinage dudit support (6) de la ligne à surveiller.

**2.** Dispositif selon la revendication 1, caractérisé en ce que ledit élément conducteur (14) est constitué par une plaque conductrice agencée dans le fond du coffret (4).

**3.** Dispositif selon la revendication 1, caractérisé en ce que l'élément conducteur (14) est constitué par l'une au moins des parois du coffret (4), en matériau conducteur ou semi-conducteur, et en ce que le deuxième capteur (12) sensible aux variations transitoires de la tension homopolaire est placé à l'extérieur dudit coffret (4).

**4.** Dispositif selon l'une des revendications 1 à 3, caractérisé en ce que ledit premier capteur (10) est constitué par une bobine.

**5.** Dispositif selon l'une des revendications 1 à 3, caractérisé en ce que ledit deuxième capteur (12) est constitué par deux armatures conductrices formant condensateur et noyées dans le champ électrique de la ligne à surveiller.

**6.** Dispositif selon l'une des revendications 1 à 5, caractérisé en ce que le circuit électronique (8) comporte un étage de filtrage et d'amplification destiné extraire la composante fondamentale du courant homopolaire.

## Claims

**1.** A device (2) for detecting faults on an overhead electrical-energy distribution network comprising an electronic circuit (8) linked to at least a first sensor (10), which is sensitive to the transient variations in the homopolar current of the line to be monitored, and to at least a second sensor (12), which is sensitive to the transient variations in the homopolar voltage of said line, said electronic circuit (8) performing a fault detection based on comparing the signs of said transient variations in the homopolar currents and of said transient variations in the homopolar voltages, characterized in that the electronic circuit (8), linked to at least a first sensor (10), is in a box (4) which is integral with the line support (6), and in that the box (4) includes at least one conducting element (14) designed to confer a known orientation on the electric field lines in the vicinity of said support (6) of the line to be monitored.

2. A device according to Claim 1, characterized in that said conducting element (14) consists of a conducting plate arranged in the bottom of the box (4).

3. A device according to Claim 1, characterized in that the conducting element (14) consists of at least one of the walls of the box (4), made of conducting or semiconducting material, and in that the second sensor (12), which is sensitive to the transient variations in the homopolar voltage, is placed outside said box (4).

4. A device according to one of Claims 1 to 3, characterized in that said first sensor (10) consists of a coil.

5. A device according to one of Claims 1 to 3, characterized in that said second sensor (12) consists of two conducting electrodes forming a capacitor and being submerged in the electric field of the line to be monitored.

6. A device according to one of Claims 1 to 5, characterized in that the electronic circuit (8) includes a filtering and amplification stage designed to extract the fundamental component of the homopolar current.

**Patentansprüche**

1. Vorrichtung (2) zur Erfassung von Defekten an einem Freileitungsnetz zur Verteilung von elektrischer Energie, mit einem elektronischen Schaltkreis (8), der verbunden ist mit wenigstens einem ersten Meßfühler (10), der auf Momentanschwankungen des gleichpoligen Stroms der zu überwachenden Leitung anspricht, und mit wenigstens einem zweiten Meßfühler (12), der auf Momentanschwankungen der gleichpoligen Spannung dieser Leitung anspricht, wobei der elektronische Schaltkreis (8) eine Erfassung des Defekts basierend auf dem Vergleich der Vorzeichen der Momentanschwankungen der gleichpoligen Ströme und der Momentanschwankungen der gleichpoligen Spannungen ausführt, dadurch gekennzeichnet daß sich der mit wenigstens einem ersten Meßfühler (10) verbundene elektronische Schaltkreis (8), in einem Schaltkastengehäuse (4) befindet, das mit dem Leitungsträger (6) fest verbunden ist, und daß das Schaltkastengehäuse (4) wenigstens ein Leiterelement (14) umfaßt, das dazu bestimmt ist, den elektrischen Feldlinien in der Nähe des Trägers (6) der zu überwachenden Leitung eine bekannte Ausrichtung zu verleihen.

2. Vorrichtung nach Anspruch 1, dadurch gekennzeichnet, daß das Leiterelement (14) durch eine leitende Platte gebildet ist, die im Boden des Schaltkastengehäuses (4) angeordnet ist.

3. Vorrichtung nach Anspruch 1, dadurch gekennzeichnet, daß das Leiterelement (14) durch wenigstens eine der Wände des Schaltkastengehäuses (4) aus leitendem oder halbleitendem Material gebildet ist und daß der zweite Meßfühler (12), der auf Momentschwankungen der gleichpoligen Spannung anspricht, außerhalb des Schaltkastengehäuses (4) angeordnet ist.

4. Vorrichtung nach einem der Ansprüche 1 bis 3, dadurch gekennzeichnet, daß der erste Meßfühler (10) durch eine Spule gebildet ist.

5. Vorrichtung nach einem der Ansprüche 1 bis 3, dadurch gekennzeichnet, daß der zweite Meßfühler (12) durch zwei leitende Beschlagteile gebildet ist, die in dem elektrischen Feld der zu überwachenden Leitung einen Kondensator und Kerne bilden.

6. Vorrichtung nach einem der Ansprüche 1 bis 5, dadurch gekennzeichnet, daß der elektronische Schaltkreis (8) eine Filter- und Verstärkungsstufe zum Extrahieren der Grundschwingung des gleichpoligen Stroms umfaßt.

FIG_1

FIG_2

FIG_5

FIG_3

FIG_4

FIG_6

FIG_7